# EUROPEAN PATENT APPLICATION

(11) **EP 1 536 463 A1**
(43) Date of publication of application: **01.06.2005**
(21) Application number: 03425765.9
(22) Date of filing: 28.11.2003
(51) Int. Cl.: H01L 21/331, H01L 21/336, H01L 29/10, H01L 29/739, H01L 29/78, H01L 29/08

(54) **Method for manufacturing a power device with insulated trench-gate having controlled channel length and corresponding device**

(71) Applicant: STMicroelectronics S.r.l., 20041 Agrate Brianza (Milano) (IT)
(72) Inventor: Alessandria, Antonino Sebastiano, 95131 Catania (IT); Fragapane, Leonardo, 95121 Catania (IT)
(74) Representative: Ferrari, Barbara

(57) **Abstract**

A method is described for manufacturing a power device (15) with insulated trench-gate (18), integrated on a semiconductor substrate (1), providing at least the steps of:
□ realising at least a body region (4) in the semiconductor substrate (1);
□ realising a surface source region (6) on the body region (4);
□ etching the semiconductor substrate (1) and forming a trench (17) to realise the trench-gate structure (18).
The method provides the further step of:
□ forming a deep portion (6a) of the source region (6) along the trench (17).
A semiconductor power device (15) with insulated gate and trench-gate structure (18) is also described.
Advantageously, the method comprises the further step of:
□ forming a deep body portion (4a) along said trench extending deeper than the deep source portion (6a).

## Description

### Field of application

The present invention relates to a method for manufacturing a power device with insulated gate and trench-gate structure having controlled channel length and corresponding device.

More specifically, the invention relates to a method for manufacturing a power device with insulated gate and trench-gate structure, of the type integrated on a semiconductor substrate, providing at least a step of:
■ realising at least a body region in the semiconductor substrate;
■ realising a surface source region on the body region;
■ etching said semiconductor substrate and forming a trench to realise said trench-gate structure.

The invention also relates to a power semiconductor device with insulated gate and trench-gate structure, comprising:
- a semiconductor substrate;
- at least a body region realised in said semiconductor substrate;
- a surface source region realised on said body region; as well as
- a trench-gate structure effective to form a gate region of said device and realised by means of a trench made in said semiconductor substrate.

The invention particularly relates, but not exclusively, to a method for controlling the channel length in a power device of the IGBT type (Insulated Gate Bipolar Transistor) and the following description is made with reference to this field of application for convenience of illustration only.

### Prior art

As it is well known, power devices of the IGBT type (Insulated Gate Bipolar Transistor) are applied at best in the field of circuits requiring high voltage and current with a moderate switching frequency, such as motor control or the use in continuity groups.

The advantageous performances of IGBT devices derive from the fact of simultaneously having the advantages of a bipolar transistor (high conductivity) and those of a field-effect MOS transistor (control voltage with high input resistance).

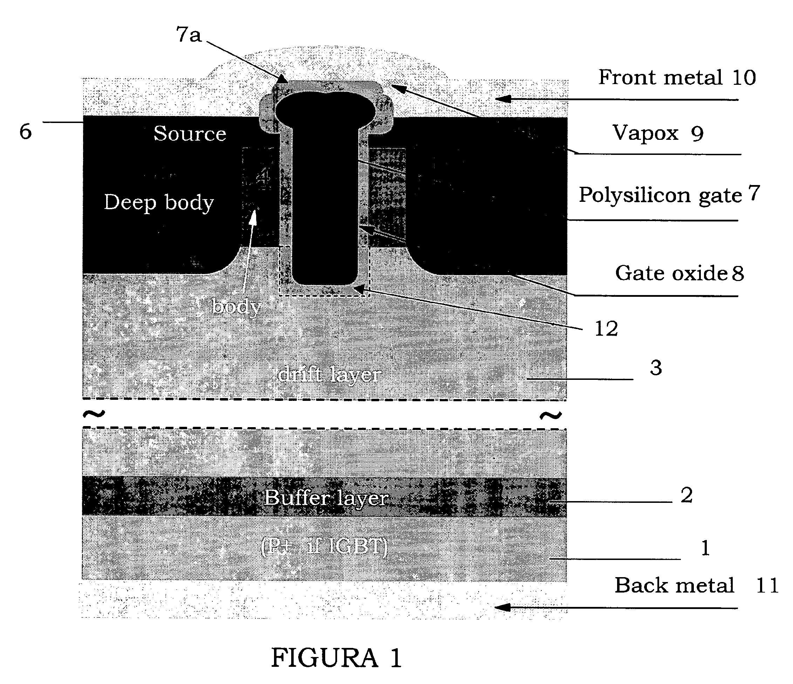

These IGBT devices can be generally manufactured in two versions: a first embodiment called "planar gate" and a second embodiment called "trench-gate". Figure 1 is a cross-sectional view of a trench-gate IGBT device.

The structure of a "trench-gate" IGBT device comprises a substrate 1 of semiconductor material of a first conductivity type, particularly of the P+ type whereon a semiconductor epitaxial layer is grown, split into buffer layer 2 and drift layer 3, of a second conductivity type, particularly of the N+ and N- type respectively. Two differently-doped P regions are formed on the layer 3: a body region 4 and a deep body region 5. A source N region 6 is realised in the body region 4.

Although figure 1 relates to an IGBT device, the same integrated structure also defines a MOS Power device which does not only comprise the substrate 1. Reference will be made hereafter to the IGBT device for convenience of illustration, the description being however not limited to this embodiment.

The IGBT device of figure 1 comprises a trench-gate structure 7a forming the gate region of the IGBT device and it is realised by means of a trench made in the semiconductor substrate 1 filled in with a polysilicon layer 7. The trench-gate structure 7a is separated from the other portions of the IGBT device by means of a silicon oxide coating layer 8 grown on the trench walls. A deposit of a dielectric layer 9, a metal contact 10 realised on the device front and a metal contact 11 realised on the back of the semiconductor substrate 1 complete the device.

In particular, layers 1 and 3 are the conduction electrodes of the bipolar transistor comprised in the IGBT device, while the MOS transistor of the IGBT device comprises the source 6 and drift layer 3 regions and the trench-gate structure 7a.

In power IGBT devices of the trench-gate type a channel region is formed along the vertical walls of the trench made in the semiconductor substrate 1. Therefore, in such a device, the channel length is given by the difference between the source-body junction depth and the body-drift layer depth.

In particular, the conduction channel region is formed at the interface between the silicon oxide coating layer 8 and the semiconductor layer 3, along the trench walls, in the body region 4.

The main advantages of a power IGBT device of the trench-gate type with respect to a device manufactured with the planar technology are the following:
1) removal of the J-FET resistance with subsequent decrease in conduction losses,
2) possibility of considerably increasing the device integration scale with subsequent increase in the current density.

On the other hand, power IGBT devices of the trench-gate type have some drawbacks.

In particular, a first drawback is linked to the upper edge of the trench-gate structure 7a which causes the formation of a beak during the growth of the gate oxide coating layer 8. This unevenness causes a thickening of the electric field, due to the well known peak effect, with a subsequent worsening of the gate oxide break-down voltage.

A second drawback is instead linked to the considerable increase in the gate oxide area, for the same device active area, even in useless areas, i.e. in areas wherein no channel is formed, such as the portion 12 of the gate oxide layer 8 in figure 1. This involves an increase in the stray capacities linked to the device gate terminal.

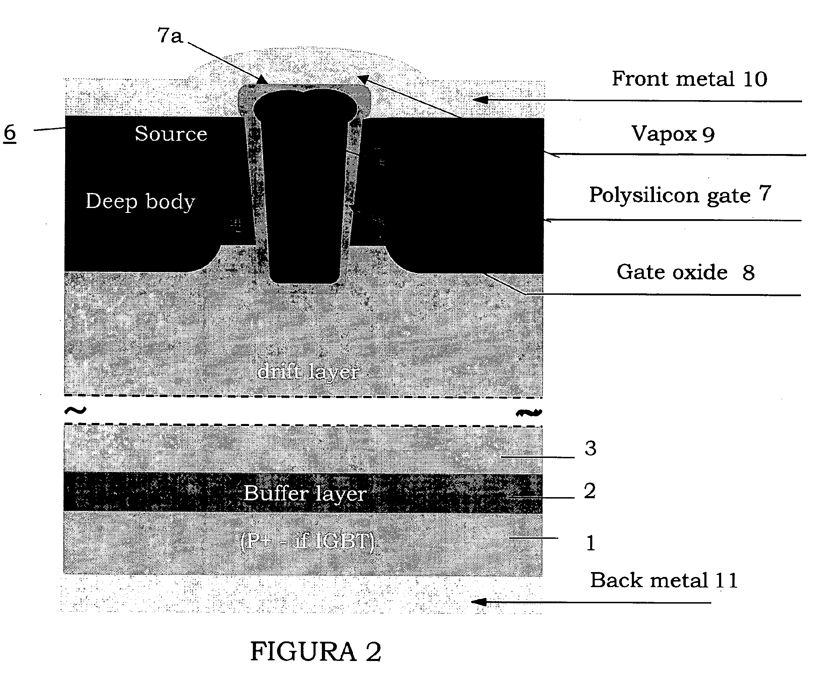

A first prior art solution to solve the first drawback is to round the upper edge of the trench-gate structure 7a at the interface with the semiconductor substrate 1 surface, as shown in figure 2, when digging the semiconductor substrate 1 to avoid the formation of the beak during the growth thereof. In this figure 2, all the regions in common with figure 1 have the same numeral references.

A trench having a substantially countersunk profile is thus obtained. Nevertheless, this solution is quite complex from the technological point of view.

A second prior art solution to solve the problem linked to the upper edge of the trench-gate structure 7a is to use a recessed polysilicon structure (etchback of the polysilicon protruding from the trench) in order to confine the polysilicon layer filling in the trench inside the trench itself. Therefore the edge at the upper end of the trench-gate structure 7a is spaced from the device active part.

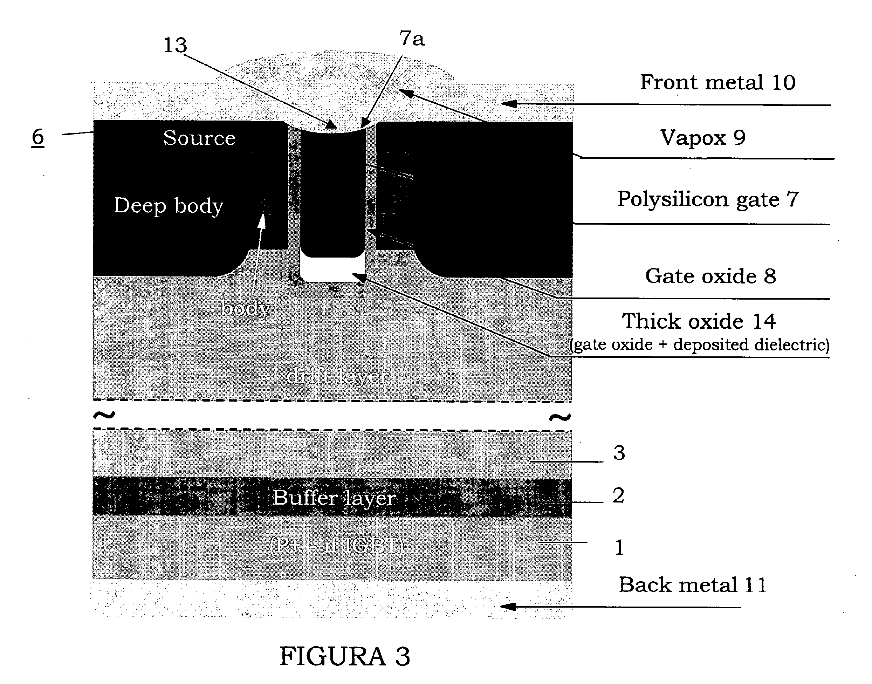

All this is shown in detail in figure 3, wherein the comparison with figure 1 clearly shows the effect of the polysilicon etchback even under the edge level of the trench-gate structure 7a, obtaining a concave surface 13. In this figure 3, all the regions in common with figures 1 and 2 have the same numeral references.

Nevertheless, this approach involves technical complications due, for example, to the etchback step of the polysilicon layer 7 which must have a controlled overetch step since the depth must be lower than the source junction depth.

It is also known to try and solve the problem linked to the considerable increase of the gate oxide area introducing, on the trench bottom under the gate region, a thick oxide layer 14 called Thick-oxide (gate oxide + deposited dielectric), as always shown in figure 3. This thick oxide layer 14 often fills in the trench bottom up to reach the body region 4 level.

This solution improves both the device break-down (the oxide serves as field-ring) and the gate oxide break-down since the wall portion, wherein a variation of the silicon crystallographic orientation occurs, is excluded from the thin oxide area, and the stray capacity linked to the gate terminal.

Nevertheless, this approach involves considerable complications due, for example, to the trench filling with an oxide layer of the LTO (Low Temperature Oxide) type.

Moreover, since in an IGBT power device of the trench-gate type the conduction loss component linked to the JFET resistance is almost completely removed, the channel resistance, being strictly dependent on the channel length, becomes one of the main components of conduction losses.

In particular, in the structure realised through polysilicon etchback, shown in figure 3, the body-source junction depth is a very important parameter to limit conduction losses.

In fact, for the device correct operation, the source region 6 must be deeper than the level whereto the polysilicon layer is recessed, therefore the thermal budget attributed to the dopant implanted in the substrate 1 to realise the source region must be carefully controlled and it highly depends on the type of dopant being used.

The technical problem underlying the present invention is to provide a method for controlling the channel length in a MOS power device with insulated gate of the trench-gate type, having such structural and functional features as to allow the channel length to be determined independently from the thermal budget and from the variety of dopant used to realise the source region, thus overcoming the limits and drawbacks still affecting prior art devices.

### Summary of the invention

The solution idea underlying the present invention is to implant the dopant also on the side walls of the trench-gate structure in order to extend the source region on the side walls of the trench-gate structure up to a desired depth.

On the basis of this solution idea the technical problem is solved by a method as previously indicated and defined in the characterising part of claim 1.

The problem is also solved by a device as previously indicated and defined in the characterising part of claim 8.

The features and advantages of the method and device according to the invention will be apparent from the following description of embodiments thereof given by way of non-limiting example with reference to the attached drawings.

### Brief description of the drawings

In the drawings:
- Figure 1 is a cross-sectional schematic view of a power device of the trench-gate type realised according to the prior art;
- Figure 2 schematically shows a first alternative embodiment of the device of figure 1;
- Figure 3 schematically shows a second alternative embodiment of the device of figure 1;
- Figure 4 is a cross-sectional schematic view of a power device realised according to the invention;
- Figure 5 is a cross-sectional schematic view in a process step according to a first alternative embodiment of the device of figure 4;
- Figure 6 is a cross-sectional schematic view in a process step according to a second alternative embodiment of the device of figure 4;
- Figure 7 is a cross-sectional schematic view of an alternative embodiment of the power device realised according to the invention.

### Detailed description

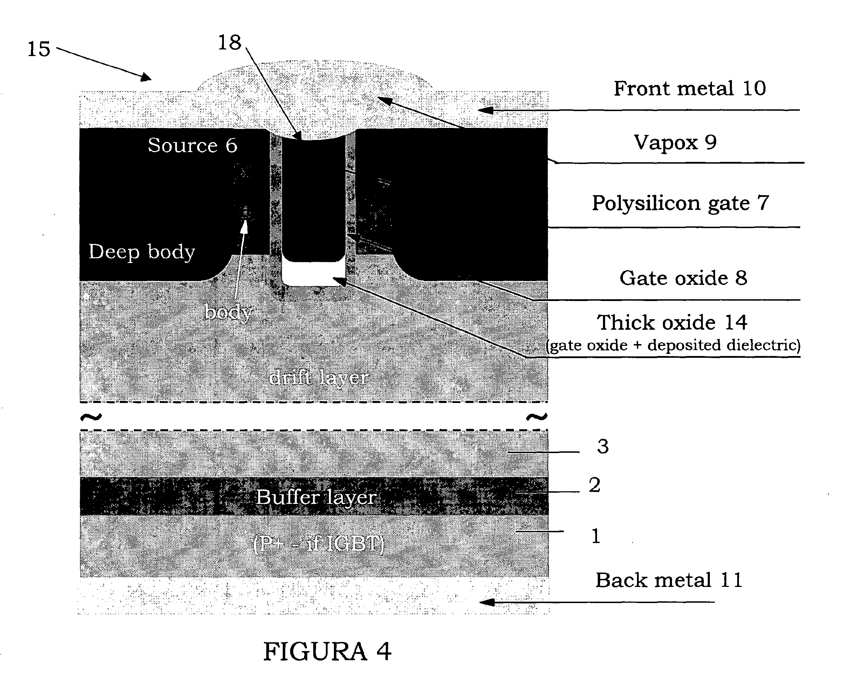

With reference to figures 4 to 7, a method is described for manufacturing a MOS power device 15 with insulated gate of the trench-gate type having controlled channel length and a corresponding MOS power device 15.

With particular reference to the example of figure 4, the sequence of steps of the method according to the invention leading to the formation of a power device 15 of the above-mentioned type is shown hereafter.

The method steps and the structures being described hereafter do not form a complete process flow for manufacturing a power device. In particular, the present invention can be implemented together with the integrated circuit manufacturing techniques presently used in this field and only those commonly used process steps being necessary to understand the invention are described hereafter.

The figures representing cross sections of a semiconductor device during the manufacturing are not drawn to scale, but they are instead drawn in order to show the important features of the invention.

For convenience of illustration, elements being structurally and functionally identical with respect to the prior art will be given the same numeral references.

The method according to the invention thus provides the following steps:
■ realisation of a starting semiconductor substrate 1 (of a first conductivity type, particularly of the N+ type for a MOS power transistor or of a second conductivity type, particularly of the P+ type for an IGBT device);
■ epitaxial growth of a layer of the N- type (drift layer) 3 with possible preventive growth of a buffer layer of the N+ type 2 at the interface with the semiconductor substrate 1;
■ realisation of edge structures of the power device 15 by means of a field oxide layer;
■ exposure of the active area of the device 15 by removing the field oxide layer;
■ realisation of a body region 4 on the semiconductor substrate 1, for example by means of an opencast implant of the P type;
■ realisation of a deep body region 5 of the device 15 being adjacent to the body region 4, for example by means of an implant of the P+ type with photoresist mask;
■ realisation of a source region 6 on body regions 4, 5, for example by means of an implant of the N+ type with photoresist mask;
■ alignment of a hard mask 16 for etching the semiconductor substrate 1;
■ etching of the semiconductor substrate 1 to realise a trench-gate structure 18 by realising a trench 17 having, in a lower or bottom portion of the trench 17, a U-profile, for example through anisotropic dry etching.

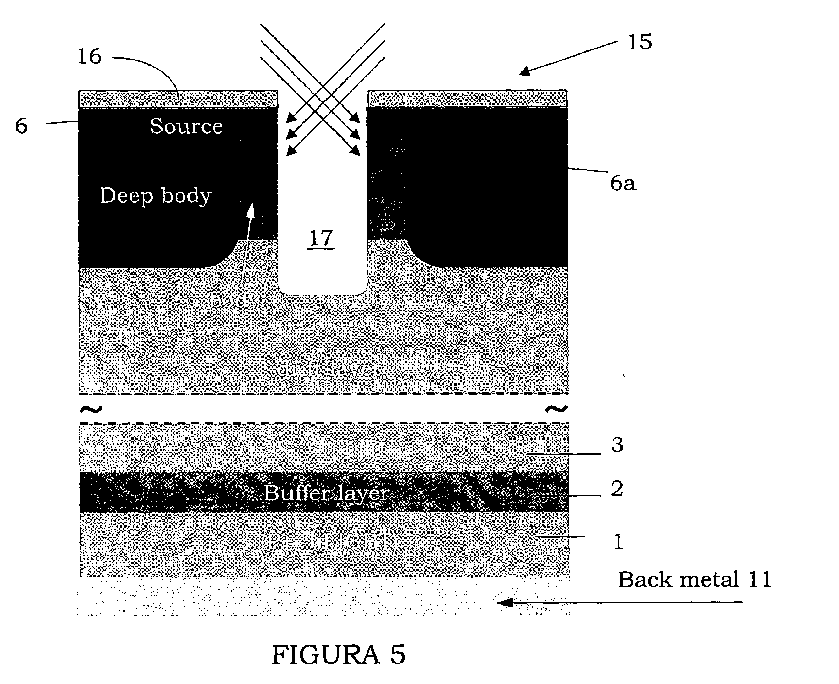

The invention then provides the further step of:
■ implant of a variety of dopant equal to that implanted to realise the source region 6 with such a slope as to partially implant the dopant in the walls of the trench 17 up to a predetermined depth as shown in figure 5, thus forming at least a deep source portion 6a on the walls of the trench 17.

The implant is advantageously performed on two quadrants (i.e. in two directions having opposite angles with respect to the vertical).

The variety implanted is activated by using one of the following thermal processes. For example, the thermal budget related to the sacrificial oxidation step could be used.

In this way the cleaning of the trench 17 walls and the activation of the dopant composing the source deep portion 6a on the trench 17 walls are simultaneously realised.

The method according to the invention is traditionally carried on with the following steps:
■ removal of the sacrificial oxide layer from the trench 17 walls;
■ formation of a coating layer 8 which coats the trench 17, to realise a gate dielectric layer, for example through oxidation;
■ deposit of a conductive layer 7 in the trench 17 to complete the trench-gate strucutre 18 and thus the gate region of the device 15;
■ continuation of the manufacturing process to define front metallisation contacts 10, final passivation and back metallisation 11, similarly to known technologies.

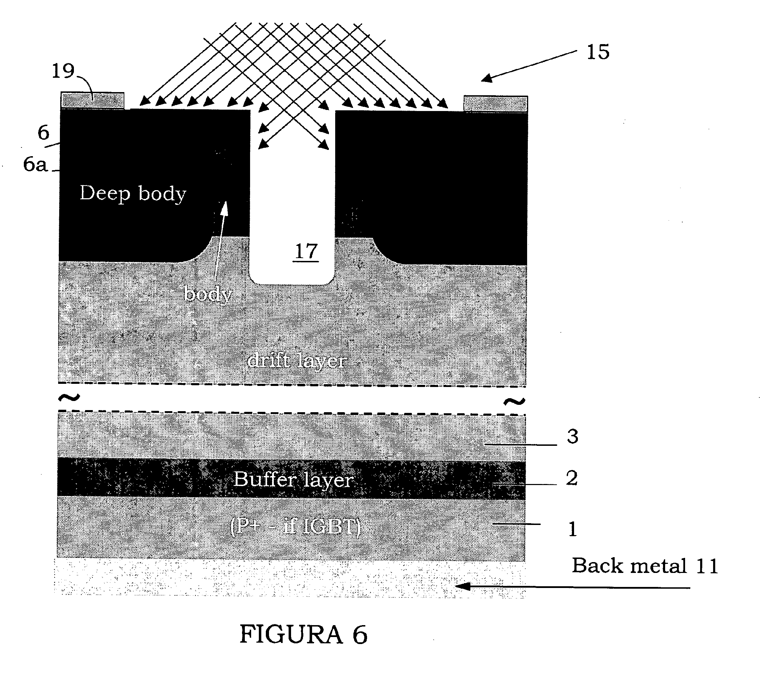

In an alternative embodiment of the method according to the invention, shown in figure 6, the manufacturing steps are thus modified after realising the deep body region 5 of the device 15:
■ formation of a hard mask 16 on the semiconductor device 1;
■ etching of the semiconductor layer 1 to realise a trench 17 having, in a lower or bottom portion of the trench 17 itself, a U-profile, for example through anisotropic dry etching;
■ removal of the hard mask 16;
■ formation of a mask 19, for example resist, on the semiconductor 1;
■ realisation of the source region 6 and of the relevant deep portion 6a through a sloping or angled implant of a doping variety, as shown in figure 6. Also in this embodiment the implant is advantageously performed on two quadrants;
■ diffusion of the source region 6 and of the deep portion 6a for example through an oxidation step; the possible so-grown oxide layer also serves as sacrificial oxide for the walls of the trench 17.

The process according to the invention is carried on as the above-described process starting from the sacrificial oxide removal.

A power device 15 with insulated gate having a trench-gate structure 18 is thus obtained, being realised on a P+ semiconductor material substrate 1 whereon an epitaxial semiconductor layer split into buffer layer 2 and drift layer 3, of the N+ and N- type respectively, is grown. Two differently-doped P regions are formed on the layer 3: a body region 4 developing along a trench 17 and a deep body region 5 being adjacent thereof, generally deeper than the body region 4. A source N region 6 is realised on body regions 4, 5.

The device 15 comprises a trench-gate structure 18 realising the device gate region, the trench-gate structure 18 being realised by means of the trench 17 made in the semiconductor substrate 1 filled in with a polysilicon layer 7. The trench-gate structure 18 is separated from the other portions of the integrated structure by means of a silicon oxide coating layer 8 grown on the walls of the trench 17.

According to the invention, the source region 6 realised on the semiconductor substrate 1 comprises a deep source portion 6a extending along the walls of the trench 17 for a predetermined length.

A dielectric layer 9, a metal contact 10 realised on the semiconductor substrate 1 front and a metal contact 11 realised on the semiconductor substrate back traditionally complete the device 15.

As already mentioned, it is important to underline that this solution allows the device channel length to be adjusted almost independently from overall thermal budgets. For example, if a source region 6 is to be realised by means of an arsenic implant, the subsequent source junction depth would always be very small, even with a considerable thermal budget. This problem is more and more emphasised when a recessed polysilicon structure is used, since a polysilicon layer being lower than the edge on the device top, but simultaneously higher than the source-body junction, should be realised.

This would make the etching step of the recessed polysilicon critical.

On the contrary, realising the implant on the side walls of the trench 17 to realise the deep portion 6a allows an overall source region 6, 6a with the desired depth to be obtained, only linked to geometric factors.

This feature of the method and device according to the invention is very important since, besides removing some criticalities in the process, it also helps the device electric features be improved. In fact, when calculating the conduction losses of a power device, once the J-FET component is eliminated by means of the trench-gate structure, the main component is the one linked to the channel. This component is particularly important for devices belonging to a voltage class being lower than 50 V. The solution according to the invention, by realising a short channel, allows the conduction loss component to be reduced to a minimum.

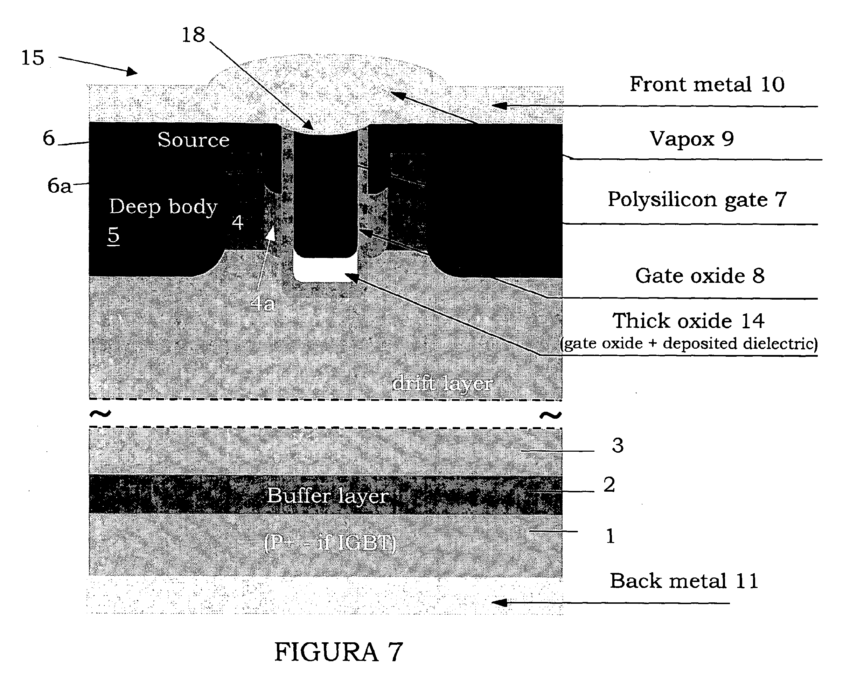

An alternative embodiment of the method according to the invention is now described, consisting in adding a sloping or angled implant to optimise the body region 4, whose final structure is shown in figure 7.

A deep portion 4a of the body region 4 is thus formed, being adjacent to the body region 4 on the walls of the trench 17 and extending up to a predetermined depth being higher than the source region 6 portion.

Advantageously, this implant is performed simultaneously with the sloping implant to realise the deep source portion 6a (just before or just after). In this alternative embodiment, the implant for realising the body region 4 is used to ensure the electric continuity between the channel region and the deep body region 5, while the sloping implant is used to complete the channel region, making the dopant concentration uniform and adjusting the device threshold voltage.

An alternative embodiment of the device 15 according to the invention is thus obtained, wherein the body region 4, realised on the semiconductor substrate 1, advantageously comprises a deep body portion 4a realised along said trench 17.

In particular, the deep body portion 4a realised on the semiconductor substrate 1 is deeper than the deep source portion 6a realised along the trench 17.

This is a very important result. In fact, in a MOS power device 15, having a variable concentration of the semiconductor substrate 1 along the channel involves short channel or punch-through effects.

According to the invention, by extending the body region 4, 4a along the walls of the trench 17, the dopant concentration, for example boron, in the channel region is contained at a very reduced distance from the interface. Therefore, the channel region is not determined by a diffusion profile, with a high concentration gradient, as it happens instead in traditional devices, but it is mainly determined by the implant and thus with a box concentration profile. This reduces the possible above-mentioned undesired effects.

In this alternative embodiment, as previously mentioned, the active portion of the body region 4 coincides with the deep portion 4a realised by means of the sloping dopant implant, while the surface-implanted body region 4 simply serves to ensure the electric continuity between the deep body region 5 and the channel region.

By virtue of this fact, the dedicated implant for realising the surface-realised body region 4 can be removed and the electric continuity between the deep body region 5 and the channel region can be ensured by means of an already available dopant implant in the normal process flow for realising the device 15 according to the invention, provided that it is of the same variety and with a lower concentration, such as for example the implant used for realising the ring region.

The method according to the invention can be implemented on any prior art structure in the field of trench-gate power devices with insulated gate.

In conclusion, the method and device according to the invention allow:
■ determination of the channel length independently from the thermal budget and the variety of dopant used for realising the source region;
■ reduction of the predetermined channel resistance almost independently from the process being used;
■ when using a trench-gate structure 18 with a polysilicon layer being recessed in the trench 17, independence between the thermal processes used to form the source and the other structures and the etching process used to recess the polysilicon.

## Claims

1. A method for manufacturing a power device (15) with insulated gate and trench-gate structure (18), of the type integrated on a semiconductor substrate (1), providing at least a step of:
■ realising in said semiconductor substrate (1) at least a body region (4);
■ realising a surface source region (6) on said body region (4);
■ etching said semiconductor substrate (1) and forming a trench (17) to realise said trench-gate structure (18);
the method being **characterised in that** it provides the further step of:
■ forming a deep portion (6a) of said source region (6) along said trench (17).

2. A method for manufacturing a power device according to claim 1, **characterised in that** said surface source region (6) is formed on said semiconductor substrate (1) around said trench (17) simultaneously with said deep source portion (6a).

3. A method for manufacturing a power device according to claim 1, **characterised in that** it further comprises the steps of:
■ forming a deep portion (4a) of said body region (4) along said trench (17), said deep body portion (4a) extending up to a predetermined depth being higher than said deep source portion (6a).

4. A method for manufacturing a power device according to claim 1, **characterised in that** said formation step of said deep source portion (6a) is performed through a sloping implant step of a doping variety.

5. A method for manufacturing a power device according to claim 3, **characterised in that** said formation step of said deep body portion (4a) is performed through a sloping implant step of a doping variety.

6. A method for manufacturing a power device according to claim 4 or 5, **characterised in that** said sloping implant step of a doping variety is performed on two quadrants.

7. A method for manufacturing a power device according to claim 6, **characterised in that** said sloping implant steps of a doping variety to realise said deep source portion (6a) and said deep body portion (4a) are realised in sequence.

8. A semiconductor power device (15) with insulated gate and trench-gate structure (18), of the type comprising:
- a semiconductor substrate (1);
- at least a body region (4) realised in said semiconductor substrate (1);
- a surface source region (6) realised on said body region (4); as well as
- a trench-gate structure (18) effective to form a gate region of said device (15) and realised by means of a trench (17) made in said semiconductor substrate (1).
said device (15) being **characterised in that** said surface source region (6) comprises a deep source portion (6a) realised along said trench (17).

9. A semiconductor power device (15) according to claim 8, **characterised in that** said body region (4) comprises a deep body portion (4a) realised along said trench (17).

10. A semiconductor power device (15) according to claim 9, **characterised in that** said deep body portion (4a) extends up to a predetermined depth being higher than said deep source portion (6a).
